# EUROPÄISCHE PATENTANMELDUNG

(11) **EP 3 543 985 A1**
(43) Veröffentlichungstag der Anmeldung: **25.09.2019**
(21) Anmeldenummer: 18163089.8
(22) Anmeldetag: 21.03.2018
(51) Int. Cl.: G09B 9/04, G01M 17/00

(54) **SIMULIEREN VERSCHIEDENER VERKEHRSSITUATIONEN FÜR EIN TESTFAHRZEUG**

(71) Anmelder: dSPACE digital signal processing and control engineering GmbH, 33102 Paderborn (DE)
(72) Erfinder: Amelunxen, Hendrik, 33184 Altenbeken (DE); Franke, Rainer, 33178 Borchen (DE); Wächter, Christian, 33100 Paderborn (DE)

(57) **Zusammenfassung**

Die Erfindung betrifft ein Verfahren zum Simulieren verschiedener Verkehrssituationen für ein Testfahrzeug (E), mit folgenden Verfahrensschritten:
- simuliertes Fahren des Testfahrzeugs (E) durch ein simuliertes vorbestimmtes Straßennetz,
- simuliertes randomisiertes Fahren einer Mehrzahl anderer Fahrzeuge durch das Straßennetz,
- Erfassen wenigstens eines Fahrparameters für das Testfahrzeug (E),
- Erfassen wenigstens eines jeweiligen Fahrparameters für alle anderen Fahrzeuge innerhalb einer vorbestimmten Testzone (T) um das Testfahrzeug (E) herum,
- Überprüfen, ob sich das Testfahrzeug (E) und wenigstens ein anderes Fahrzeug in der Testzone (T) in einer vordefinierten Verkehrssituation befinden, wobei eine vordefinierte Verkehrssituation gegeben ist durch wenigstens einen Fahrparameter des Testfahrzeugs (E) und wenigstens einen Fahrparameter eines anderen Fahrzeugs innerhalb der Testzone (T), und
- für den Fall, dass sich das Testfahrzeug (E) und wenigstens ein anderes Fahrzeug in der Testzone (T) in einer vordefinierten Verkehrssituation befinden, Beenden des randomisierten Fahrens wenigstens eines anderen Fahrzeugs, das sich in der vordefinierten Verkehrssituation befindet, und Erzwingen eines vorbestimmten Fahrmanövers des anderen, nicht mehr randomisiert fahrenden Fahrzeugs, wobei das vorbestimmte Fahrmanöver durch die erfasste vordefinierte Verkehrssituation vorgegeben ist. Auf diese Weise kann beim Simulieren verschiedener Verkehrssituationen für ein Testfahrzeug (E) die Häufigkeit verwertbarer Situationen, in denen tatsächlich eine autonome oder teilautonome Reaktion des Testfahrzeugs provoziert wird, erhöht werden, ohne den Realismus der Simulation wesentlich zu beeinträchtigen.

## Beschreibung

Die Erfindung betrifft ein Verfahren zum Simulieren verschiedener Verkehrssituationen für ein Testfahrzeug mit den Verfahrensschritten:
- simuliertes Fahren des Testfahrzeugs durch ein simuliertes vorbestimmtes Stra-ßennetz, und
- simuliertes randomisiertes Fahren einer Mehrzahl anderer Fahrzeuge durch das Straßennetz. Die Erfindung betrifft außerdem ein nichtflüchtiges, computerlesbares Speichermedium mit darauf abgespeicherten Befehlen, die bei ihrer Ausführung auf einem Prozessor ein solches Verfahren bewirken, sowie ein entsprechendes Computersystem zur Durchführung dieses Verfahrens.

Die Erfindung betrifft damit das randomisierte Testen eines Testfahrzeugs. Im Allgemeinen weist ein derartiges Testfahrzeug ein wenigstens einen Sensor aufweisendes Sensorsystem zum Erfassen von Objekten in der Umgebung des Fahrzeugs auf und wird wenigstens teilweise aufgrund von von dem Sensorsystem erfassten Signalen gesteuert. Entsprechende Sensoren des Testfahrzeugs sind im Allgemeinen Ultraschallsensoren, LIDAR-Sensoren, RADAR-Sensoren und/oder Kameras, mit denen die Umgebung des Testfahrzeugs erfasst wird, um damit ein autonomes oder zumindest teilautonomes Fahren des Testfahrzeugs zu erzielen. Entsprechende Sensorsysteme sind außerdem Systeme zum Empfang von Daten von anderen Fahrzeugen oder stationären Vorrichtungen des Straßenverkehrs, um durch Auswertung der Daten ein autonomes oder zumindest teilautonomes Fahren des Fahrzeugs zu erzielen (Car2X-Kommunikation).

Bei einem autonomen Fahren muss der Fahrer, zumindest über lange Strecken, gar nicht mehr in den Fahrprozess eingreifen. Beim teilautonomen Verfahren ist es zumindest so, dass das Fahrzeug automatisch, also ohne Eingriff des Fahrers, auf bestimmte Verkehrssituationen reagiert und damit z.B. eine Kollision mit einem vorausfahrenden langsameren Fahrzeug vermeidet, indem bei Annäherung an dieses vorausfahrende Fahrzeug automatisch ein Bremsvorgang eingeleitet wird. Um derartige automatisierte Fahrmanöver durchführen zu können, wird mit Hilfe der Sensoren des Sensorsystems erfasst, wo sich in der Umgebung des Fahrzeugs andere Fahrzeuge, Fußgänger oder andere Hindernisse befinden.

Bevor ein Fahrzeug, das mit einem entsprechenden Sensorsystem ausgerüstet ist, in der Praxis, also auf dem realen Straßennetz, zum teilautonomen oder autonomen Fahren betrieben werden kann, müssen eine Vielzahl von Tests durchgeführt werden, um sicherzustellen, dass das teilautonome bzw. autonome Fahren tatsächlich verlässlich und sicher ist. Zwar erfolgen derartige Tests, typischerweise in einem fortgeschrittenen Stadium, auch auf öffentlichen Straßen mit realen Fahrzeugen. Vorab werden in der Regel jedoch Tests in Form von Simulationen durchgeführt. Um die Reaktion des Sensorsystems für eine hohe Anzahl unterschiedlicher, auch unvorhergesehener, Situationen zu überprüfen, ist es im Stand der Technik bekannt, derartige Tests randomisiert durchzuführen, d.h. möglichst realitätsnah, ohne bestimmte Verkehrssituationen voreinzustellen. Damit werden derartige randomisierte Tests jedoch sehr zeitaufwändig, weil die durchgeführten Fahrmanöver definitionsgemäß nicht vordefiniert werden und man deshalb auf verwertbare Situationen, die eine Reaktion des Testfahrzeugs provozieren, warten muss.

Aus der DE 10 2005 047 591 A1 ist ein Verfahren zur Entlastung des Fahrers bei der Bedienung eines Kraftfahrzeugs mit einer Vielzahl von Fahrerassistenzsystemen zur Durchführung einer Vielzahl unterschiedlicher Fahrmanöver sowie Mitteln zur Gewinnung von Situationsdaten zur Beschreibung der aktuellen Fahrsituation bekannt. Das Verfahren umfasst die Schritte: Gewinnung von Situationsdaten durch das Kraftfahrzeug, anhand der Situationsdaten Bestimmung einer begrenzten Menge situationsgerechter Fahrmanöver durch das Kraftfahrzeug und Einigung zwischen Kraftfahrzeug und Fahrer auf die Ausführung eines einzigen situationsgerechten Fahrmanövers.

Weiterhin sind aus der DE 10 2006 044 086 A1 ein System und Verfahren zur virtuellen Simulation von Verkehrssituationen bekannt, mit einer Anzeigeeinheit zur bildhaften Anzeige der virtuellen Verkehrssituationen und einer Eingabeeinheit, und mit zumindest einem modellierten Referenzfahrzeug und zumindest einem weiteren modellierten Verkehrsteilnehmer, wobei das Referenzfahrzeug eine modellierte Detektionseinrichtung zur Erfassung der virtuellen Umgebung des Referenzfahrzeugs aufweist und das Verhalten des Referenzfahrzeugs während einer simulierten Verkehrssituation zumindest zeitweise unter Berücksichtigung der durch die Detektionseinrichtung erfassten Informationen erfolgt. Insbesondere soll damit ein System zur Analyse von unfallkritischen Gefahrensituationen bereitgestellt werden.

Schließlich sind aus der DE 10 2017 116 192 A1 ein Verfahren und Systeme zum Verwenden von virtuellen Daten zum Testen und Trainieren von Parkplatzerfassungssystemen bekannt. Aspekte der Erfindung integrieren eine virtuelle Fahrumgebung mit Sensormodellen (z. B. von einem Radarsystem), um virtuelle Radardaten in relativ großen Mengen in einer relativen kurzen Zeitspanne bereitzustellen. Die Sensormodelle erfassen Werte für relevante Parameter eines Trainingsdatensatzes. Relevante Parameter können in den aufgezeichneten Daten randomisiert werden, um einen diversen Trainingsdatensatz mit minimalem Bias zu gewährleisten. Da die Fahrumgebung virtualisiert ist, kann der Trainingsdatensatz zusammen mit Cround-Truth-Daten generiert werden. Die Cround-Truth-Daten werden dazu verwendet, die tatsächlichen Positionen, die zum Trainieren eines Parkplatzklassifikationsalgorithmus zum Erfassen der Begrenzungen des freien Platzes verwendet werden, zu annotieren.

Es ist die Aufgabe der Erfindung, beim Simulieren verschiedener Verkehrssituationen für ein Testfahrzeug die Häufigkeit verwertbarer Situationen, in denen tatsächlich eine autonome oder teilautonome Reaktion des Testfahrzeugs provoziert wird, zu erhöhen, ohne den Realismus der Simulation wesentlich zu beeinträchtigen.

Diese Aufgabe wird durch den Gegenstand des Patentanspruchs 1 gelöst. Bevorzugte Weiterbildungen finden sich in den Unteransprüchen.

Erfindungsgemäß ist somit ein Verfahren zum Simulieren verschiedener Verkehrssituationen für ein Testfahrzeug mit folgenden Verfahrensschritten vorgesehen:
- simuliertes Fahren des Testfahrzeugs durch ein simuliertes vorbestimmtes Stra-ßennetz,
- simuliertes randomisiertes Fahren einer Mehrzahl anderer Fahrzeuge durch das Straßennetz,
- Erfassen wenigstens eines Fahrparameters für das Testfahrzeug,
- Erfassen wenigstens eines jeweiligen Fahrparameters für andere, vorzugsweise für alle anderen Fahrzeuge innerhalb einer vorbestimmten Testzone um das Testfahrzeug herum,
- Überprüfen, ob sich das Testfahrzeug und wenigstens ein anderes Fahrzeug in der Testzone in einer vordefinierten Verkehrssituation befinden, wobei eine vordefinierte Verkehrssituation gegeben ist durch wenigstens einen Fahrparameter eines anderen Fahrzeugs innerhalb der Testzone, insbesondere optional auch durch weitere Fahrparameter anderer Fahrzeuge oder des Testfahrzeugs, und
- für den Fall, dass sich das Testfahrzeug und wenigstens ein anderes Fahrzeug in der Testzone in einer vordefinierten Verkehrssituation befinden, Beenden des randomisierten Fahrens wenigstens eines anderen Fahrzeugs, das sich in der vordefinierten Verkehrssituation befindet, und Erzwingen eines vorbestimmten Fahrmanövers des anderen, nicht mehr randomisiert fahrenden Fahrzeugs, wobei das vorbestimmte Fahrmanöver durch die erfasste vordefinierte Verkehrssituation vorgegeben ist.

Erfindungsgemäß wird also überprüft, ob eine vordefinierte Verkehrssituation vorliegt. Eine solche vordefinierte Verkehrssituation umfasst wenigstens einen Fahrparameter des Testfahrzeugs und wenigstens einen Fahrparameter eines anderen Fahrzeugs innerhalb der Testzone und ist immer dann gegeben, wenn diese Fahrparameter erfüllt sind, unabhängig von den erfassten Fahrparametern anderer Fahrzeuge.

Erfindungswesentlich ist, dass das Fahren der anderen Fahrzeuge randomisiert simuliert wird, worunter verstanden wird dass sich die anderen Fahrzeuge in der Simulation stochastisch, aber nach vorbestimmten Regeln durch das Straßennetz bewegen, gemäß derer das Testfahrzeug nicht anders behandelt wird als alle anderen Fahrzeuge. Die vorbestimmten Regeln können für alle anderen Fahrzeuge gleich oder auch unterschiedlich sein. Insbesondere kann durch die Regeln für jedes andere Fahrzeug eine Parametrierung vorgegeben sein, z.B. Leistung, Art des Fahrzeugs usw. Weiterhin kann vorgesehen sein, dass das jeweilige andere Fahrzeug eine vorbestimmte Route fährt oder diese Route statistisch wählt. Darüber hinaus kann vorgegeben sein, wie schnell ein anderes Fahrzeug fährt, auf welchen Spuren einer Straße es typischerweise fährt und ob bzw. in welchem Maß es sich an Verkehrsregeln hält. Insbesondere gilt für alle Fahrzeuge, dass sie sich realitätsnah, d.h. plausibel, durch den Verkehr bewegen, bei ihrer Fahrt also andere Fahrzeuge berücksichtigen sowie das Straßennetz in der Regel nicht verlassen.

Gleichwohl kann es bei diesem randomisierten Fahren der Fahrzeuge zu kritischen Situationen kommen, in denen eine Gefährdungssituation entsteht bzw. entstehen kann. Eine Gefährdungssituation kann insbesondere eine Kollision zwischen wenigstens zwei Fahrzeugen oder eine einer solchen Kollision vorausgehende Situation sein. Eine Gefährdungssituation kann aber auch eine Situation sein, bei der es nur zur Gefährdung eines einzelnen Fahrzeugs, wie des Testfahrzeugs alleine, kommt, dieses z.B. ins Schleudern kommt oder von der Straße abkommt oder abkommen kann. Im Übrigen kann das Fahren des Testfahrzeugs durch das vorbestimmte Straßennetz entlang einer vorbestimmten Route erfolgen oder wenigstens teilweise zufällig sein, so dass z.B. bei jeder nächsten Kreuzung rein statistisch entschieden wird, ob, und wenn ja, wohin das Testfahrzeug abbiegt.

Wie weiter oben schon ausgeführt, gilt auch für das Testfahrzeug im Rahmen der vorliegenden Erfindung, dass dieses vorzugsweise ein wenigstens einen Sensor aufweisendes Sensorsystem zum Erfassen von Objekten in der Umgebung des Fahrzeugs aufweist und wenigstens teilweise aufgrund von von dem Sensorsystem erfassten Signalen gesteuert wird. Auf diese Weise kann simuliert werden, wie sich das Testfahrzeug in kritischen Situationen autonom bzw. teilautonom verhält. Das Erfassen von Objekten in der Umgebung des Testfahrzeugs durch das Sensorsystem ist natürlich abhängig von der Reichweite und der Ausrichtung der jeweiligen Sensoren. Typische Sensoren umfassen Ultraschallsensoren, Kameras, RADAR- und LIDAR-Sensoren, wobei die letzteren drei in der Regel eine größere Reichweite haben als Ultraschallsensoren.

Das Fahren des Testfahrzeugs im simulierten Straßennetz ist natürlich virtuell. Gleichwohl sind verschiedene Simulationsmodi möglich, bei denen Hardware in unterschiedlichem Maße beteiligt ist. Bei einer Komplettsimulation spricht man von "Software in the loop" oder "Model in the Loop". Hier wird alles simuliert, also nicht nur das Straßennetz und die anderen Fahrzeuge, sondern auch das Testfahrzeug mit seinem Sensorsystem, die Fahrt des Testfahrzeugs durch das Straßennetz und die Erfassung seiner Umgebung durch wenigstens einen Sensor des Sensorsystems dabei. Von "Hardware in the loop" spricht man, wenn z.B. das tatsächliche Steuergerät und/oder ein tatsächlicher Sensor des Sensorsystems hardware-mäßig beim Testen verwendet wird. Schließlich spricht man von "Vehicle in the loop", wenn mit einem Testfahrzeug real gefahren wird. Im Allgemeinen findet das reale Fahren des Testfahrzeugs dann auf einem abgesperrten Gelände, wie auf einem stillgelegten Flugplatz statt, wobei den Sensoren des Testfahrzeugs simulierte Signale zugeführt werden, die das simulierte Straßennetz und die simulierte Umgebung mit den anderen Fahrzeugen repräsentieren.

Das Fahren des Testfahrzeugs durch das vorbestimmte Straßennetz kann also durch einen realen Fahrer (Vehicle in the loop) oder durch einen simulierten Fahrer (Software/Model/Hardware in the loop) erfolgen. Im Falle eines simulierten Fahrers erfolgt das Fahren des Testfahrzeugs durch das Straßennetz vollständig in Simulation. Wie zuvor erläutert, ist jedoch auch möglich, ein reales Testfahrzeug auf einem abgesperrten Areal fahren zu lassen, nämlich mittels eines realen Fahrers, wobei den Sensoren des Sensorsystems des Testfahrzeugs dann simulierte Signale zugeleitet werden, um andere Fahrzeuge in der Umgebung des Testfahrzeugs zu simulieren. Insgesamt handelt es sich hierbei um ein reales teilautonomes Fahren des Testfahrzeugs. Das Testfahrzeug kann, real oder in Simulation, natürlich auch vollautonom durch das Straßennetz fahren. Weiterhin ist es auch möglich, ein virtuelles Fahrzeug im Rahmen einer Hardware/Model/Software-in-the-Loop-Simulation von einem realen Fahrer fahren zu lassen, beispielsweise in einem Fahrsimulator mit nachgestellter Fahrerkabine, die beispielsweise ein Lenkrad, Pedale, einen Schalthebel und weitere Bedienelemente eines realen Fahrzeugs umfasst.

Die Testzone um das Testfahrzeug kann unterschiedlich dimensioniert sein. Insbesondere ist die Testzone um das Testfahrzeug vorzugsweise wenigstens so groß, dass eine Mehrzahl von anderen Fahrzeugen in dieser Zone und damit in der Nähe des Testfahrzeugs fahren können. Gemäß einer bevorzugten Weiterbildung der Erfindung ist vorgesehen, dass die Abmessungen der Testzone um das Testfahrzeug herum wenigstens der maximalen Reichweite des Sensorsystems entsprechen. Die Testzone deckt damit den gesamten Bereich ab, der aufgrund der Sensoren des Sensorsystems erfasst werden kann. Damit ist die Simulation besonders realitätsnah, da all die anderen Fahrzeuge berücksichtigt werden können, die mit Hilfe des Sensorssystems in der Praxis tatsächlich auch erfasst werden können.

Im Übrigen ist gemäß einer bevorzugten Weiterbildung der Erfindung vorgesehen, dass die Testzone bis direkt an das Testfahrzeug heranreicht und/oder das Testfahrzeug vollständig umgibt, und sich damit im Extremfall auch derartige andere Fahrzeuge vollständig in der Testzone befinden, die, entsprechend einer kritischen Situation, in direktem Kontakt mit dem Testfahrzeug stehen, z.B. bei einer oder kurz vor einer Kollision.

Hinsichtlich der Fahrparameter, die von dem Testfahrzeug und den anderen Fahrzeugen erfasst werden, kommen unterschiedliche Parameter in Betracht, die eine Verkehrssituation definieren können. Gemäß einer bevorzugten Weiterbildung der Erfindung werden als Fahrparameter die Position des Testfahrzeugs bzw. wenigstens eines anderen Fahrzeugs oder/und die Geschwindigkeit des Testfahrzeugs bzw. wenigstens eines anderen Fahrzeugs oder/und die Ausrichtung des Testfahrzeugs bzw. wenigstens eines anderen Fahrzeug oder/und die Beschleunigung des Testfahrzeugs bzw. wenigstens eines anderen Fahrzeugs verwendet. Zusätzliche Parameter sind natürlich auch denkbar, wie grundsätzlich auch die Art des Testfahrzeugs bzw. eines anderen Testfahrzeugs, also ob es sich z.B. um einen Kleinwagen, eine Limousine, einen SUV, einen Kleintransporter oder einen Lastwagen handelt, und ob das Fahrzeug z.B. einen Anhänger mit einer bestimmten Länge zieht. Im Übrigen wird vorzugsweise nicht nur ein einziges anderes Fahrzeuge berücksichtigt, sondern es findet die Berücksichtigung einer Mehrzahl anderer Fahrzeuge in der Testzone statt.

Was eine vordefinierte Verkehrssituation hinsichtlich dieser Fahrparameter angeht, so können grundsätzlich genau festgelegte Einzelwerte für die Fahrparameter definiert sein. Vorzugsweise ist eine vordefinierte Verkehrssituation jedoch durch einen jeweiligen Wertebereich für einen berücksichtigten Parameter gegeben. Auf diese Weise ergeben sich deutlich mehr Verkehrssituationen im Rahmen des randomisierten Testens, gemäß derer von dem rein randomisierten Testen abgewichen wird, indem wenigstens ein anderes Fahrzeug ein durch die entsprechende Verkehrssituation vorgegebenes Fahrmanöver ausführt. Im Übrigen führt vorzugsweise ein derartiges anderes Fahrzeug ein solches vorgegebenes Fahrmanöver aus, welches Fahrzeug bei der Definition der Verkehrssituation auch beteiligt ist, also mit seinem wenigstens einen Fahrparameter einen Teil der Definition darstellt.

Was die Positionen der anderen Fahrzeuge angeht, so sind diese vorzugsweise durch ihre Relativpositionen zu dem Testfahrzeug gegeben. Eine derartige Relativposition ist vorzugsweise eine relative Längsposition zum Testfahrzeug, eine relativ Querposition zum Testfahrzeug oder/und die Fahrspur, auf dem ein anderes Fahrzeug relativ zum Testfahrzeug fährt. Es ist weiterhin vorteilhaft, wenn die Geschwindigkeit und/oder die Beschleunigung der anderen Fahrzeuge zumindest wahlweise in Relation zum Testfahrzeug angegeben sind. In dieser Ausgestaltung kann beispielsweise eine vordefinierte Verkehrssituation vollständig oder teilweise dadurch definiert sein, dass ein weiteres Fahrzeug eine bestimmte Relativgeschwindigkeit zum Testfahrzeug einnimmt, unabhängig von der absoluten Geschwindigkeit des Testfahrzeugs oder des anderen Fahrzeugs.

Weiterhin ist gemäß einer bevorzugten Ausgestaltung der Erfindung im Rahmen der Simulation das randomisierte Fahren der Mehrzahl anderer Fahrzeuge durch das Straßennetz nur innerhalb eines vorbestimmten Abstands zu dem Testfahrzeug vorgesehen. Dabei entspricht der vorbestimmte Abstand von dem Testfahrzeug vorzugsweise der Testzone um das Testfahrzeug herum. Vorzugsweise ist also vorgesehen, dass im Rahmen der Simulation die anderen Fahrzeuge außerhalb der Testzone "generiert" werden, dann in die Testzone hineinfahren, und sofern ein anderes Fahrzeug die Testzone vorne, hinten oder seitlich wieder verlässt, wird es aus der Simulation herausgenommen.

Grundsätzlich ist es denkbar, dass lediglich eine einzige vordefinierte Verkehrssituation vorgesehen ist, in der von dem rein randomisierten Testen abgewichen wird. Gemäß einer bevorzugten Weiterbildung der Erfindung sind jedoch eine Mehrzahl von vordefinierten Verkehrssituationen vorgegeben, bei deren Erreichen ein vorbestimmtes Fahrmanöver wenigstens eines anderen Fahrzeugs provoziert wird.

Grundsätzlich kann es auch sein, dass durch die erfasste vordefinierte Verkehrssituation vorgegeben ist, eines von einer Mehrzahl von vorbestimmten Fahrmanövern durch wenigstens ein anderes Fahrzeug durchzuführen. So kann z. B. ein derartiges vorbestimmtes Fahrmanöver statistisch aus einer vorgegebenen Gruppe ausgewählt werden. Gemäß einer bevorzugten Weiterbildung der Erfindung ist jedoch vorgesehen, dass durch die erfasste vordefinierte Verkehrssituation vorgegeben ist, genau ein vorbestimmtes Fahrmanöver unter Beteiligung eines anderen Fahrzeugs oder mehrerer anderer Fahrzeuge durchzuführen. Auf diese Weise kann besonders effektiv vorbestimmt werden, welche Verkehrssituationen sich besonders für das Provozieren einer bestimmten kritischen Verkehrssituation eignen.

Gemäß einer bevorzugten Weiterbildung der Erfindung ist vorgesehen, dass die Fahrparameter des Testfahrzeugs und wenigstens eines anderen Fahrzeugs, vorzugsweise eines solchen anderen Fahrzeugs, das an der kritischen Verkehrssituation beteiligt ist, wenigstens ab dem Zeitpunkt aufgezeichnet werden, zu dem erfasst worden ist, dass eine vordefinierte Verkehrssituation vorliegt. Auf diese Weise sind entsprechende Situationen auch nachträglich analysierbar und können definiert wiederholt werden. Vorzugsweise werden folgende Fahrparameter des Testfahrzeugs und der an der kritischen Verkehrssituation beteiligten anderen Fahrzeuge aufgezeichnet: die Position des Testfahrzeugs bzw. wenigstens eines anderen Fahrzeugs oder/und die Geschwindigkeit des Testfahrzeugs bzw. wenigstens eines anderen Fahrzeugs oder/und die Ausrichtung des Testfahrzeugs bzw. wenigstens eines anderen Fahrzeug oder/und die Beschleunigung des Testfahrzeugs bzw. wenigstens eines anderen Fahrzeugs.

Weiterhin betrifft die Erfindung ein nicht-flüchtiges, computerlesbares Speichermedium mit darauf abgespeicherten Befehlen, die bei ihrer Ausführung auf einem Prozessor ein Verfahren, wie zuvor beschrieben, bewirken.

Schließlich betrifft die Erfindung auch ein Computersystem, das zur Durchführung eines Verfahrens, wie zuvor beschrieben, eingerichtet ist.

Nachfolgend wird die Erfindung im Rahmen eines bevorzugten Ausführungsbeispiels anhand der Zeichnungen weiter im Detail erläutert.

In der Zeichnung zeigen
- Fig. 1: schematisch eine erste Verkehrssituation gemäß einem bevorzugten Ausführungsbeispiel der Erfindung,
- Fig. 2: schematisch eine zweite Verkehrssituation gemäß einem bevorzugten Ausführungsbeispiel der Erfindung,
- Fig. 3: schematisch eine dritte Verkehrssituation gemäß einem bevorzugten Ausführungsbeispiel der Erfindung,
- Fig. 4: eine GUI gemäß einem bevorzugten Ausführungsbeispiel der Erfindung, über welche GUI an einem Bildschirm eine vordefinierte Verkehrssituation eingegeben werden kann.

Bei der vorliegenden Erfindung ist es wesentlich, die Effizienz randomisierter Tests zu erhöhen, indem die zeitliche Dichte interessanter, verwertbarer Ereignisse in der Simulation erhöht wird. Der Test von Steuergeräten für das hochautomatisierte (teilautonome) oder autonome Fahren setzt, im Vergleich zu den Tests von Fahrdynamikregelsystemen usw., nicht nur eine wesentlich höhere Anzahl von simulierten Testkilometern voraus. Vielmehr müssen insbesondere auch verschiedenste Verkehrssituationen simuliert werden. Bei konventionellen Verfahren müssen diese Verkehrssituationen im Vorfeld exakt vordefiniert werden. Da aber der Testaufwand für Funktionalitäten beim teilautonomen oder vollständig autonomen Fahren derart hoch sind, besteht die Notwendigkeit, dass auf der einen Seite Testszenarien mit einer Vielzahl beteiligter Objekte einfach erstellt werden können. Auf der anderen Seite sollen auch Testszenarien abgebildet werden können, die nicht exakt im Vorfeld definiert wurden, um auf diese Weise die Testtiefe zu vergrößern. Schließlich muss ein Algorithmus in einem Fahrzeug, das teilautonom oder autonom fährt, in jeder beliebigen Fahrsituation korrekt und verlässlich funktionieren.

Zu diesem Zweck sind randomisierte Tests besonders geeignet. Statt kurze Fahrmanöver exakt vorzudefinieren, bewegt sich das virtuelle Fahrzeug über einen langen Zeitraum hinweg auf einem großen virtuellen Straßennetz und interagiert dabei mit zahlreichen anderen Verkehrsteilnehmern, im Wesentlichen mit anderen Fahrzeugen, auch "Fellows" genannt. Solche Tests sind, insbesondere, wenn sie in Echtzeit durchgeführt werden, naturgemäß sehr zeitaufwändig, da man auf interessante Situationen, die eine Reaktion des Testfahrzeugs provozieren, warten muss. Daher wird mit dem Verfahren gemäß dem vorliegend beschriebenen bevorzugten Ausführungsbeispiel der Erfindung die Häufigkeit derartiger Situationen erhöht.

Das Verfahren zum Simulieren verschiedener Verkehrssituationen für ein Testfahrzeug gemäß dem vorliegend beschriebenen bevorzugten Ausführungsbeispiel der Erfindung sieht nun folgende Verfahrensschritte vor:
Ein virtuelles Testfahrzeug fährt im Rahmen einer Simulation, hier einer Komplettsimulation (Software in the loop) durch ein simuliertes vorbestimmtes Straßennetz. Dabei kann dem Testfahrzeug eine vorbestimmte Route vorgegeben sein oder das Testfahrzeug kann statistisch durch das Straßennetz fahren, indem bei jeder Abzweigungsmöglichkeit rein statistisch neu entschieden wird, ob, und wenn ja, welche Abzweigung das Testfahrzeug nimmt. Um das Testfahrzeug herum findet ein simuliertes randomisiertes Fahren einer Mehrzahl anderer Fahrzeuge durch das Straßennetz statt. Diese anderen Fahrzeuge verhalten sich selbständig und plausibel und gegenüber dem Testfahrzeug nicht anders als gegenüber anderen Fahrzeugen. Daraus entstehen stetig neue, nicht im Vorfeld definierte Verkehrssituationen, wie in der Realität auch. Allerdings werden in der Regel praktisch keine kritischen Verkehrssituationen erzeugt, in denen sich die automatische Reaktion des autonom oder teilautonom fahrenden Testfahrzeugs testen lässt.

Insofern sieht das Verfahren gemäß dem vorliegend beschriebenen bevorzugten Ausführungsbeispiel der Erfindung ferner vor, dass eine Mehrzahl von Fahrparametern für das Testfahrzeug erfasst werden, wie dessen Position, dessen Geschwindigkeit, dessen Orientierung und dessen Beschleunigung. Genauso werden für alle anderen Fahrzeuge innerhalb einer vorbestimmten Testzone um das Testfahrzeug herum entsprechende Fahrparameter erfasst, also Position, Geschwindigkeit, Orientierung und Beschleunigung Diese Testzone ist dabei derart dimensioniert, dass sie die Reichweite aller Sensoren eines in dem Testfahrzeug vorgesehenen Sensorsystems übersteigt. Mit anderen Worten: Alle anderen Fahrzeuge, die von Sensoren des Sensorsystems des Testfahrzeugs erfasst werden können, werden damit durch Testzone auch berücksichtigt.

Während des randomisierten Fahrens der anderen Fahrzeuge wird nun kontinuierlich überprüft, ob sich das Testfahrzeug und andere Fahrzeuge in der Testzone in einer vordefinierten Verkehrssituation befinden. Dazu sind eine Mehrzahl von Verkehrssituationen vordefiniert, die sich dazu eignen, aus einer entsprechenden Verkehrssituation eine kritische Verkehrssituation zu provozieren, in der mit einer automatischen Reaktion des Testfahrzeugs gerechnet werden kann. Derartige vordefinierte Verkehrssituationen sind gegeben durch die oben genannten Fahrparameter des Testfahrzeugs und einer festgelegten Anzahl anderer Fahrzeuge innerhalb der Testzone. Für diese Fahrparameter sind Wertebereiche vordefiniert, so dass es gewisse Toleranzen für derartige Verkehrssituationen gibt, die geeignet sind, eine kritische Verkehrssituation aktiv, also unter Aufgabe des randomisierten Fahrens von wenigstens einem anderen Fahrzeug, zu provozieren.

Für den Fall nämlich, dass sich das Testfahrzeug und die vorgegebene Anzahl anderer Fahrzeuge in der Testzone in einer vordefinierten Verkehrssituation befinden, wird das randomisierte Fahren der an der kritischen Verkehrssituation beteiligten anderen Fahrzeuge aufgegeben, und für wenigstens eines der anderen Fahrzeuge wird ein vorbestimmtes Fahrmanöver erzwungen, um eine Verkehrssituation zu provozieren, die für das Testfahrzeug kritisch ist und damit aufgrund der von den Sensoren des Sensorsystems des Testfahrzeugs erfassten Signale eine autonome oder teilautonome Reaktion des Testfahrzeugs erzeugt. Dabei gilt zusätzlich, dass mit Erfassung, dass sich das Testfahrzeug und die vorbestimmte Anzahl anderer Fahrzeuge in der Testzone in einer vordefinierten Verkehrssituation befinden, die Fahrparameter der beteiligten Fahrzeuge, einschließlich des Testfahrzeugs, aufgezeichnet werden, um die sich ergebende Situation später analysieren und gegebenenfalls definiert nachstellen zu können.

Dabei lassen sich durch Änderung von verschiedenen Parametern die Verkehrssituationen leicht variieren, nämlich durch die Änderung von Simulationsparametern, wie die Anzahl der Fahrzeuge und deren Startpositionen, die Fahrzeugparameter, wie die Fahrzeugarten, gegeben durch deren Leistung und deren Aufbau, wie PKW, LKW, mit Anhänger usw. Variiert werden können auch Parameter, wie die Sollgeschwindigkeit, Sicherheitsabstände, das Verkehrsaufkommen, die Durchschnittsgeschwindigkeiten usw.

Die vordefinierten Verkehrssituationen, die geeignet sind, eine kritische Verkehrssituation zu provozieren, können mit Hilfe von entsprechenden Wertebereichen für die erfassten Fahrparameter als abstrakte und toleranzbehaftete Situationen vordefiniert sein. Es können also Situationsmuster definiert werden, wie "rechte Spur blockiert, auf der linken Spur nähert sich ein Fahrzeug schnell von hinten, auf gleicher Spur fährt ein Fahrzeug voraus". Wird eine derartige vordefinierte Verkehrssituation erfasst, wird den beteiligten Fahrzeugen ein vorher definiertes Bewegungsverhalten aufgeprägt, wie "vorausfahrendes Fahrzeug verzögert sich mit -8 m/s² auf 15 km/h" oder "überholendes Fahrzeug hält Geschwindigkeit und schert 5 m vor dem Testfahrzeug ein".

Durch das Erkennen von solchen toleranzbehafteten Szenarien, der Auswahl der beteiligten Fahrzeuge und dem Aufprägen des vorher definierten Bewegungsverhaltens wenigstens eines anderen Fahrzeugs entstehen realistische Bewegungen von Fahrzeugen, insbesondere ohne Unstetigkeiten, so dass damit auch das Sensorsystem des Testfahrzeugs einschließlich der zu testenden Algorithmen des autonomen bzw. teilautonomen Fahrens zurechtkommen sollten. Auf diese Weise kann sichergestellt werden, dass kritische Verkehrssituationen praktisch ausschließlich am Testfahrzeug auftreten und kaum unter den anderen Fahrzeugen selbst. Mit dem Verfahren gemäß dem vorliegend beschriebenen bevorzugten Ausführungsbeispiel der Erfindung können also konkrete, zu testende Szenarien, nämlich gefährliche Situationen und mögliches Fehlverhalten, in beliebigen plausiblen Situationen getestet, aufgezeichnet und ausgewertet werden. Damit können die durchschnittlichen zeitlichen Abstände zwischen zwei kritischen Verkehrssituationen, die eine automatische Reaktion des Testfahrzeugs erwarten lässt, um Größenordnungen verringert werden..

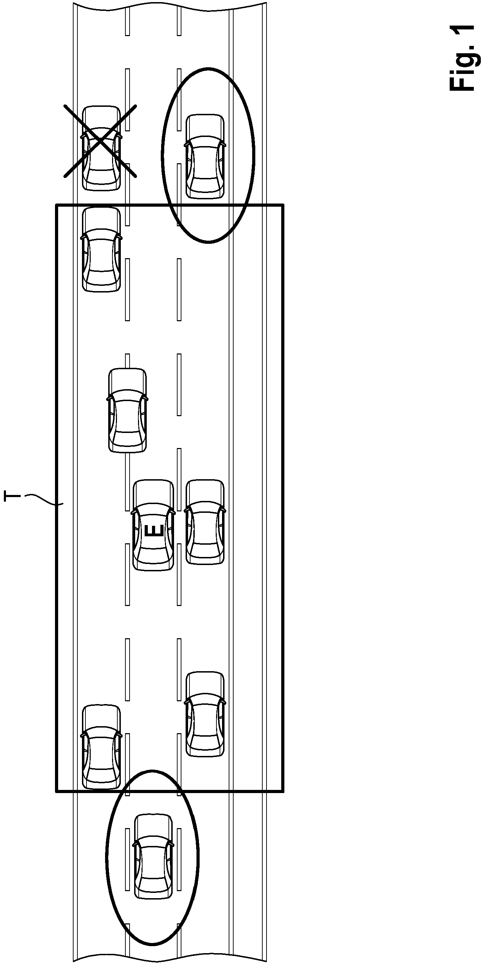

Fig. 1 zeigt einen Pulkverkehr mit einer Mehrzahl anderer Fahrzeuge um ein Testfahrzeug E, auch Ego-Fahrzeug genannt, herum. Der Übersichtlichkeit halber tragen die anderen Fahrzeuge keine eigenen Bezugszeichen. Das Testfahrzeug E befindet sich zentral innerhalb einer virtuellen Testzone T um das Testfahrzeug herum. Im Rahmen der Simulation werden Fahrzeuge außerhalb der Testzone T initialisiert (dargestellt als Ellipsen um die Fahrzeuge herum) und nach dem Austritt de-initialisiert (dargestellt durch ein Kreuz über dem Fahrzeug). Innerhalb der Testzone T verhalten sich die anderen Fahrzeuge plausibel gemäß ihrer Parametrierung. Eine vordefinierte Verkehrssituation, die zu einer Aufgabe des vollständig randomisierten Fahrens der anderen Fahrzeuge führt, kann beispielsweise wie folgt mittels vierer Kriterien definiert sein, die gleichzeitig erfüllt sein müssen:
- Kriterium 1:: Ein Fahrzeug vor dem Testfahrzeug E auf derselben Spur wie das Testfahrzeug E hat einen Abstand zum Testfahrzeug E von weniger als 50 m.
- Kriterium 2:: Ein Fahrzeug auf der Spur rechts vom Testfahrzeug E hat einen Abstand vom Testfahrzeug E von weniger als 10 m.
- Kriterium 3:: Ein Fahrzeug auf der Spur links vom Testfahrzeug E hat einen Abstand vom Testfahrzeug E von weniger als 10 m.
- Kriterium 4:: Das Testfahrzeug bewegt sich mit einer Geschwindigkeit von mindestens 40 km/h.

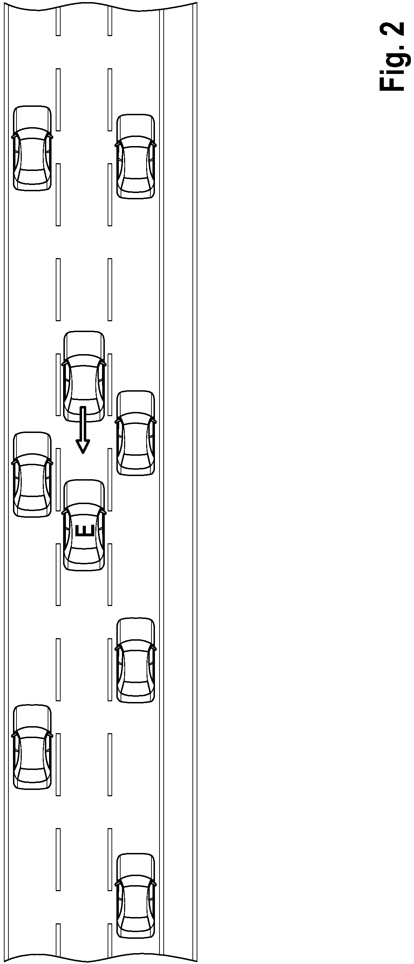

Wenn also eine Situation erkannt worden ist, dass sich ein Fahrzeug vor dem Testfahrzeug E befindet und die linke und die rechte Spur durch weitere Fahrzeuge belegt sind, kann dem vorausfahrenden Fahrzeug vor dem Testfahrzeug eine starke Bremsung aufgeprägt werden. Die Bremsverzögerung ist vorher fest einstellbar und kann in verschiedenen Simulationsdurchläufen variiert werden. Dies ist schematisch in Fig. 2 dargestellt. Das Testfahrzeug E nähert sich also dem ihm vorausfahrenden anderen Fahrzeug an, da dieses abbremst, so dass geprüft werden kann, wie sich das Testfahrzeug dabei im autonomen bzw. teilautonomen Fahrbetrieb verhält.

Die vier Kriterien, anhand derer die beispielhafte vordefinierte Verkehrssituation definiert ist, sind nicht als ausschließlich zu verstehen, d.h. sie beinhalten keine Aussage über das Vorhandensein weiterer, nicht durch die drei Kriterien erfasster weiterer Fahrzeuge innerhalb der Testzone T. Dadurch und wegen der Toleranzbehaftung der Kriterien bleibt das für einen randomisierten Test wesentliche Zufallselement erhalten. Beispielsweise lassen die Kriterien offen, ob ein Ausweichmanöver auf eine andere Fahrspur möglich ist oder ob ein hinter dem Testfahrzeug fahrendes weiteres Fahrzeug ein Bremsmanöver des Testfahrzeugs E verbietet.

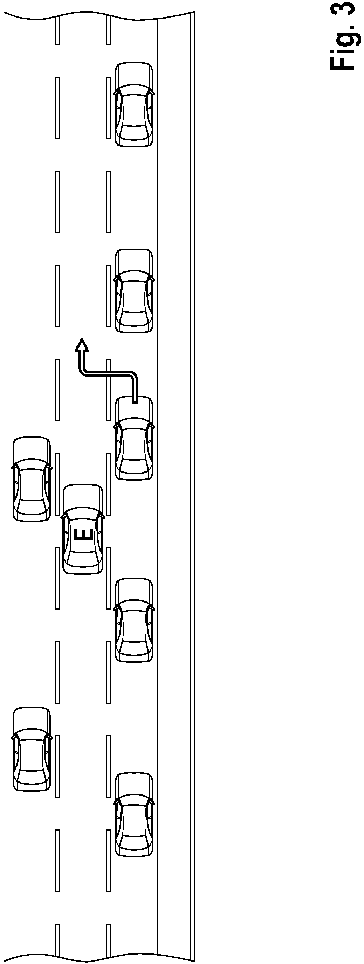

Wenn die Situationsprüfung eine Situation erkannt hat, bei der auf der rechten Spur eine gewisse Anzahl von Fahrzeugen vorhanden ist, kann ein bestimmtes Fahrzeug ausgewählt werden, das einen Spurwechsel mit vorher festgelegten Parametern durchführt. Der Spurwechsel kann in verschiedenen Simulationsdurchläufen variiert werden. Dies ist in Fig. 3 dargestellt, bei dem ein anderes Fahrzeug rechts vor dem Testfahrzeug E eine kritische Situation dadurch provoziert, dass es kurz vor dem Testfahrzeug E vor das Testfahrzeug auf die mittlere Spur fährt. Auch hier kann geprüft werden, wie sich das Testfahrzeug im autonomen bzw. teilautonomen Fahrbetrieb verhält.

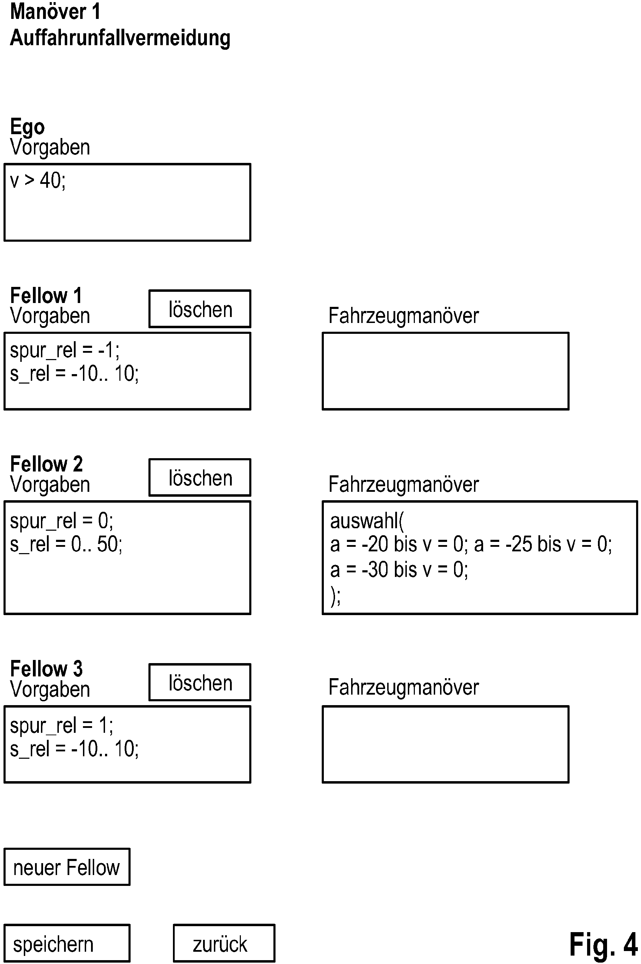

Die vordefinierten Verkehrssituationen können gemäß einem bevorzugten Ausführungsbeispiel der Erfindung über eine GUI an einem Bildschirm eingegeben werden, wie in Fig. 4 exemplarisch für das in Fig. 2 dargestellte Beispiel gezeigt. Die GUI ist Teil einer Software zur Erstellung einer Simulationsumgebung. Die Manöverdefinition besteht aus dem mit "Ego" bezeichneten Testfahrzeug E und einer vom Anwender beliebig auswählbaren Anzahl von Fellows. Für jeden Fellow ist in einem Texteingabefeld "requirements" eine Sollvorgabe in Form absoluter oder zum Testfahrzeug relativer Parameter hinterlegbar. Für jeden Fellow ist in einem zweiten Texteingabefeld "vehicle maneuver" ein Manöver definierbar, das der jeweilige Fellow ausführt, sobald alle auf der linken Seite definierten Sollvorgaben erfüllt sind. Ein leeres Feld bedeutet, dass der entsprechende Fellow kein besonderes Manöver durchführen soll. Beispielsweise soll das Testfahrzeug hier mindestens 40 km/h schnell fahren, und der erste Fellow soll sich auf der Spur links vom Testfahrzeug in einem Abstand von höchsten 10 m vor oder hinter dem Testfahrzeug E befinden.

### Bezugszeichenliste

- E: Testfahrzeug
- T: Testzone

## Patentansprüche

1. Verfahren zum Simulieren verschiedener Verkehrssituationen für ein Testfahrzeug (E), mit folgenden Verfahrensschritten:
- simuliertes Fahren des Testfahrzeugs (E) durch ein simuliertes vorbestimmtes Straßennetz,
- simuliertes randomisiertes Fahren einer Mehrzahl anderer Fahrzeuge durch das Straßennetz,
- Erfassen wenigstens eines Fahrparameters für das Testfahrzeug (E),
- Erfassen wenigstens eines jeweiligen Fahrparameters für alle anderen Fahrzeuge innerhalb einer vorbestimmten Testzone (T) um das Testfahrzeug (E) herum,
- Überprüfen, ob sich das Testfahrzeug (E) und wenigstens ein anderes Fahrzeug in der Testzone (T) in einer vordefinierten Verkehrssituation befinden, wobei eine vordefinierte Verkehrssituation gegeben ist durch wenigstens einen Fahrparameter eines anderen Fahrzeugs innerhalb der Testzone (T) oder durch wenigstens einen Fahrparameter des Testfahrzeugs (E) und wenigstens eines Fahrparameter eines anderen Fahrzeugs innerhalb der Testzone, und
- für den Fall, dass sich das Testfahrzeug (E) und wenigstens ein anderes Fahrzeug in der Testzone (T) in einer vordefinierten Verkehrssituation befinden, Beenden des randomisierten Fahrens wenigstens eines anderen Fahrzeugs, das sich in der vordefinierten Verkehrssituation befindet, und Erzwingen eines vorbestimmten Fahrmanövers des anderen, nicht mehr randomisiert fahrenden Fahrzeugs, wobei das vorbestimmte Fahrmanöver durch die erfasste vordefinierte Verkehrssituation vorgegeben ist.

2. Verfahren nach Anspruch 1, wobei das Testfahrzeug (E) ein wenigstens einen Sensor aufweisendes Sensorsystem zum Erfassen von Objekten in der Umgebung des Fahrzeugs aufweist und wenigstens teilweise aufgrund von von dem Sensorsystem erfassten Signalen gesteuert wird.

3. Verfahren nach Anspruch 2, wobei die Abmessungen der Testzone (T) um das Testfahrzeug (E) hinreichend groß sind, dass eine Mehrzahl von anderen Fahrzeugen in der Testzone fahren kann.

4. Verfahren nach einem der vorhergehenden Ansprüche, wobei als Fahrparameter die Position des Testfahrzeugs (E) bzw. eines anderen Fahrzeugs oder/und die Geschwindigkeit des Testfahrzeugs (E) bzw. eines anderen Fahrzeugs oder/und die Ausrichtung des Testfahrzeugs (E) bzw. eines anderen Fahrzeugs oder/und die Beschleunigung des Testfahrzeugs (E) bzw. eines anderen Fahrzeugs dient.

5. Verfahren nach einem der vorhergehenden Ansprüche, wobei eine vordefinierte Verkehrssituation durch einen jeweiligen Wertebereich für einen berücksichtigten Fahrparameter gegeben ist.

6. Verfahren nach einem der vorhergehenden Ansprüche, wobei zumindest ein Fahrparameter in einer vordefinierten Verkehrssituation als absoluter Wert oder als zum Testfahrzeug (E) relativer Wert vorgegeben ist.

7. Verfahren nach einem der vorhergehenden Ansprüche, wobei das simulierte randomisierte Fahren der Mehrzahl anderer Fahrzeuge durch das Straßennetz nur innerhalb eines vorbestimmten Abstands zu dem Testfahrzeug (E) erfolgt.

8. Verfahren nach Anspruch 7, wobei der vorbestimmte Abstand von dem Testfahrzeug (E) der Testzone (T) um das Testfahrzeug (E) herum entspricht.

9. Verfahren nach einem der vorhergehenden Ansprüche, wobei durch die erfasste vordefinierte Verkehrssituation vorgegeben ist, genau ein vorbestimmtes Fahrmanöver durchzuführen.

10. Verfahren nach einem der vorhergehenden Ansprüche, mit folgendem zusätzlichen Schritt:
- Aufzeichnen von Fahrparametern des Testfahrzeugs (E) und von Fahrparametern der anderen Fahrzeuge in der Testzone (T) wenigstens ab dem Zeitpunkt, zu dem erfasst worden ist, dass eine vordefinierten Verkehrssituation vorliegt.

11. Nichtflüchtiges, computerlesbares Speichermedium mit darauf abgespeicherten Befehlen, die bei ihrer Ausführung auf einem Prozessor ein Verfahren nach einem der Ansprüche 1 bis 9 bewirken.

12. Computersystem, eingerichtet zur Durchführung eines Verfahrens nach einem der Ansprüche 1 bis 10.
